# EUROPEAN PATENT SPECIFICATION

(11) **EP 2 908 144 B1**
(45) Date of publication and mention of the grant of the patent: **29.09.2021**
(21) Application number: 14155130.9
(22) Date of filing: 14.02.2014
(51) Int. Cl.: G01R 19/165, D06F 37/42, D06F 58/50

(54) **Improved electric appliance**
Verbessertes elektrisches Gerät
Appareil électrique amélioré

(43) Date of publication of application: 19.08.2015
(73) Proprietor: Electrolux Appliances Aktiebolag, 105 45 Stockholm (SE)
(72) Inventor: Cecco, Alessandro, I-33080 PORCIA (PN) (IT); Driussi, Paolo, I-33080 PORCIA (PN) (IT)
(74) Representative: Maccalli, Marco

(56) References cited:
- EP-A1- 2 365 732
- DE-A1-102006 060 208

## Description

### Field of the invention

The solution according to one or more embodiments of the invention generally relates to electric appliances, such as washing, drying, washing/drying, dishwashing appliances, both for domestic and professional use. More particularly, the proposed solution relates to determination of faults in such appliances during manufacturing thereof.

### Background of the invention

Each electric household and professional electric appliance (hereinafter, appliance, for the sake of conciseness) typically comprises an inner compartment accommodating a treatment chamber accessible by a user for loading items (*e.g.*, laundry or dishware) to be treated (*e.g.*, washed and/or dried) and unloading the items after the intended treatment has been accomplished, as well as electrically-operated devices for accomplishing the intended treatment, and an electric power supply module allowing operation of such electrically-operated devices.

A commonly used electric power supply module comprises a *"Switched-Mode Power Supply"* (SMPS) arrangement (including rectifying, filtering and regulating components) on a *"Printed Circuit Board"* (PCB) support substrate (hereinafter, the PCB support substrate and the SMPS arrangement thereon will be referred to as SMPS module as a whole). Broadly speaking, each SMPS module is configured to receive an AC power supply voltage (*e.g.*, provided by the electrical mains) and to provide one or more regulated DC supply voltages (each one for driving/powering corresponding electrically-operated devices of the appliance).

EP 2 365 732 A1 discloses a system, method, and computer-readable medium for controlling power applied to a heating element. A rectifier receives AC voltage supplied from an AC voltage supply and rectifies the AC voltage to DC voltage. A pulse-width modulation controller generates and transmits a pulse-width modulation signal, and a DC voltage modulator receives the DC voltage from the rectifier and the pulse-width modulation signal from the pulse-width modulation controller. Based on the pulse-width modulation signal, the DC voltage modulator supplies an analog DC voltage signal to the heating element. A feedback circuit reports the actual DC voltage applied to the heating element to a microcontroller and, if the actual DC voltage deviates from the DC voltage encoded in the pulse-width modulation signal, the pulse-width modulation controller modulates the pulse-width modulation signal to minimize or eliminate the deviation.

DE102006060208 A1 discloses a device for determining and limiting over current in coil in three-phase or poly-phase electrical motor for use in washing machine. The device has a comparator, by which current to be measured on the common terminal post is compared in the direct current voltage intermediate circuit with a reference value. The current is supplied to an electric motor over frequency converter or an inverter with controlled half-bridges. The reference value is formed from the sum of the constant component or a part of the measured current and a fixed pre-regulated value.

### Summary of invention

The Applicant has realized that assembly operations of multiple-pieces devices, such as the SMPS module, could prove to be excessively difficult and/or inconvenient for appliance manufacturers.

Indeed, SMPS module assembly operations such as finalization/mounting of some plastic parts and wiring, as well as SMPS module fixing/mounting to the appliance, require a number of moving/maneuvers (*i.e.,* handling) by the operator. This drastically increases risks of unintentional damages (hence, faults) of the SMPS module (*e.g.*, SMPS module components de-soldering), which may severely impair operation thereof. As a result of that, a relatively high number of appliances could be marketed without being able to ensure full functionality.

The Applicant has also realized that, in order to detect SMPS module faults early *(i.e.,* during manufacturing/assembly of the appliance), electrical tests should be performed, but that performing electrical tests with a reasonably reliability and precision would require costly test apparatus.

Even worse, such electrical tests would require excessive times, which would excessively slow down the manufacturing process, thus further negatively affecting production costs.

The Applicant has tackled the problem of devising a satisfactory solution able to overcome the above-discussed, as well as other, drawbacks.

Specifically, the Applicant has found that damages resulting by assembly operations most likely affect some electronic components of the SMPS module (such as capacitive components).

In this respect, the Applicant has addressed his efforts at a (circuit and method) solution aimed at quickly and easily detecting, at substantially any suitable stage of the appliance manufacturing/assembling, whether, as a result of said assembly operations, some SMPS module components (especially, the capacitive components) have been affected by damages.

One or more aspects of the solution according to embodiments of the invention are set out in the independent claims, with advantageous features of the same solution that are indicated in the dependent claims.

An aspect of the solution according to one or more embodiments of the invention relates to a washing and/or drying appliance comprising an electric power supply assembly configured to receive an AC supply voltage and to provide a DC supply voltage therefrom, the DC supply voltage being adapted to power electrically-operated devices of the appliance. The electric power supply assembly comprises an output module for providing the DC supply voltage, and a control unit electrically coupled to at least one component of the output module for receiving a test DC supply voltage corresponding to the DC supply voltage. The control unit is further configured to provide fault indications indicative that the least one component of the output module is affected by damages upon detecting that said test DC supply voltage has a value outside a values range comprising a predetermined value of the test DC supply voltage.

According to an embodiment of the invention, the control unit comprises a test pin for receiving the test DC supply voltage.

According to an embodiment of the invention, the control unit comprises at least one interfacing pin for interfacing of the control unit to a test apparatus, the at least one interfacing pin being adapted to receive test instructions by the test apparatus and to allow the test apparatus to receive said fault indications.

According to an embodiment of the invention, said values range comprises first and second values higher and lower, respectively, than the predetermined value of the test DC supply voltage, said first and second values being set, respectively, according to maximum and minimum allowed percentage changes of the test DC supply voltage with respect to the predetermined value thereof.

According to an embodiment of the invention, said predetermined value of the test DC supply voltage is in the middle of the values range.

According to an embodiment of the invention, the electric power supply assembly is configured to provide a further DC supply voltage from said AC supply voltage, and the control unit is configured to receive a further test DC supply voltage corresponding to the further DC supply voltage, and to provide further fault indications upon detecting that said further test DC supply voltage has a value outside a further values range comprising a further predetermined value of the further test DC supply voltage. Said further values range comprises further first and second values higher and lower, respectively, than said further predetermined value, and are set by the control unit, respectively, according to said maximum and minimum allowed percentage changes of the further test DC supply voltages with respect to the further predetermined value thereof.

According to an embodiment of the invention, said further predetermined value of the further test DC supply voltage is in the middle of the further values range.

According to an embodiment of the invention, said electrically-operated devices comprise an appliance controller for managing appliance operation, said appliance controller being powered by said DC supply voltage.

According to an embodiment of the invention, the electric power supply assembly comprises a *"Switched-Mode Power Supply"* module, said output module is the output module of the *"Switched-Mode Power Supply"* module, and the at least one component of the output module comprises a capacitive arrangement.

According to an embodiment of the invention, the control unit is configured to store said fault indications.

According to an embodiment of the invention, the control unit is configured to acquire peak values of the test DC supply voltage, and to provide said fault indications upon detecting that at least one of the acquired peak values is outside said values range.

According to an embodiment of the invention, said at least one component of the output module is directly connected to the control unit, so that the test DC supply voltage is substantially equal to the DC supply voltage, or said at least one component of the output module is electrically coupled to the control unit by interposition of an impedance arrangement.

According to an embodiment of the invention, the impedance arrangement is a voltage divider receiving the DC supply voltage and providing the test DC supply voltage, the test DC supply voltage being scaled, with respect to the DC supply voltage, by a scaling factor of the voltage divider.

According to an embodiment of the invention, the control unit is powered between first and second voltages defining an operation swing of the control unit, said scaling factor allowing the test DC supply voltage to fall within said operation swing.

According to an embodiment of the invention, the predetermined value of test DC supply voltage is in the middle of the operation swing of the control unit.

According to an embodiment of the invention, the electrically-operated devices comprise a user interface. The user interface has a control panel for receiving user commands allowing to select/adjust operating parameters of the appliance, and a user interface control board for controlling appliance operation according to the user commands, the electric power supply assembly being electrically coupled with the user interface control board for powering it.

According to an embodiment of the invention, the electric power supply assembly comprises an enclosure for allowing protection of electric power supply assembly components.

According to an embodiment of the invention, the appliance is a laundry washing and/or drying appliance.

According to an embodiment of the invention, the appliance is a dishwashing appliance.

Another aspect of the solution according to one or more embodiments of the invention relates to a method for assembling a washing and/or drying appliance. The method comprises:
mounting an electric power supply assembly within the appliance and electrically coupling it to electrically-operated devices of the appliance, the electric power supply assembly having an output module for providing a DC supply voltage from an AC supply voltage for powering said electrically-operated devices, and
performing an electrical test on said electric power supply assembly comprising:
   receiving a test DC supply voltage corresponding to the DC supply voltage,
   comparing said test DC supply voltage with first and second values higher and lower, respectively, than a predetermined value of the test DC supply voltage, and
   inferring a fault condition of the output module if said test DC supply voltage is higher than said first value or lower than said second value.

According to an embodiment of the invention, the electric power supply assembly comprises a *"Switched-Mode Power Supply"* module, said mounting an electric power supply assembly within the appliance comprising:
enclosing the *"Switched-Mode Power Supply"* module within an enclosure thereby obtaining said power supply assembly, and
fixing the power supply assembly to the appliance by means of said enclosure.

According to an embodiment of the invention, the control unit comprises a test pin for receiving the test DC supply voltage, said performing an electrical test on said electric power supply assembly comprising:
connecting a test apparatus to at least one interfacing pin of the control unit, and
causing the test apparatus to provide test instructions to the control unit and to receive said fault indications.

Thanks to the proposed solution, SMPS module faults can be detected before marketing of the appliance, without making use of costly and time-wasting test apparatus. This has been achieved by means of few, low area occupation, basic components and of few elementary operations.

### Brief description of the annexed drawings

These and other features and advantages of the present invention will be made apparent by the following description of some exemplary and non limitative embodiments thereof; for its better intelligibility, the following description should be read making reference to the attached drawings, wherein:
**Figure 1A** shows a perspective view of an appliance according to an embodiment of the invention;
**Figure 1B** shows a perspective and partly exploded front view with partly removed parts of the appliance according to an embodiment of the invention;
**Figure 1C** shows a perspective and partly exploded rear view with partly removed parts of the appliance according to an embodiment of the invention;
**Figure 2** shows a perspective exploded view of an electric power supply assembly of said appliance according to an embodiment of the invention;
**Figures 3A-4A** show close-up, partly see-through front views of a part of electric power supply assemblies according to respective embodiments of the invention, and
**Figures 3B-4B** show schematic circuit representations of said parts of the electric power supply assemblies of **Figures 3A-4A****,** respectively.

### Detailed description of preferred embodiments of the invention

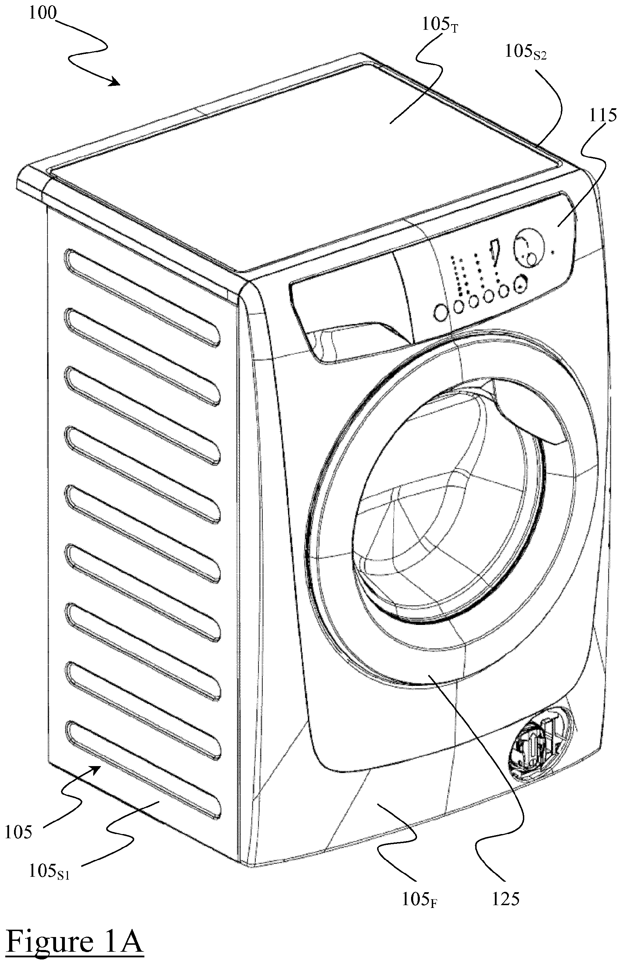

Referring now to the drawings, **Figure 1A** shows a perspective side view of an appliance **100,** for example for domestic use (*i.e.,* a household appliance), according to an embodiment of the invention.

The appliance **100** may for example be a laundry washing appliance intended to perform laundry washing operations (*i.e.,* a washer, as illustrated in the figure), a laundry drying appliance intended to perform laundry drying operations *(i.e.,* a dryer), or a laundry washing/drying appliance intended to perform both laundry washing and laundry drying operations (*i.e.,* a washer/dryer). However, as will be best understood by the following description, the principles of the invention may also be applied to other washing and/or drying appliances (*e.g*., dishwashing appliances), as well as other appliances virtually affected by electric power supply modules faults during manufacturing and/or assemblies operations.

The appliance **100** preferably comprises a substantially parallepiped-shaped cabinet **105** having front **105_{F},** top **105_{T}** and opposite side **105_{S1},105_{S2}** walls.

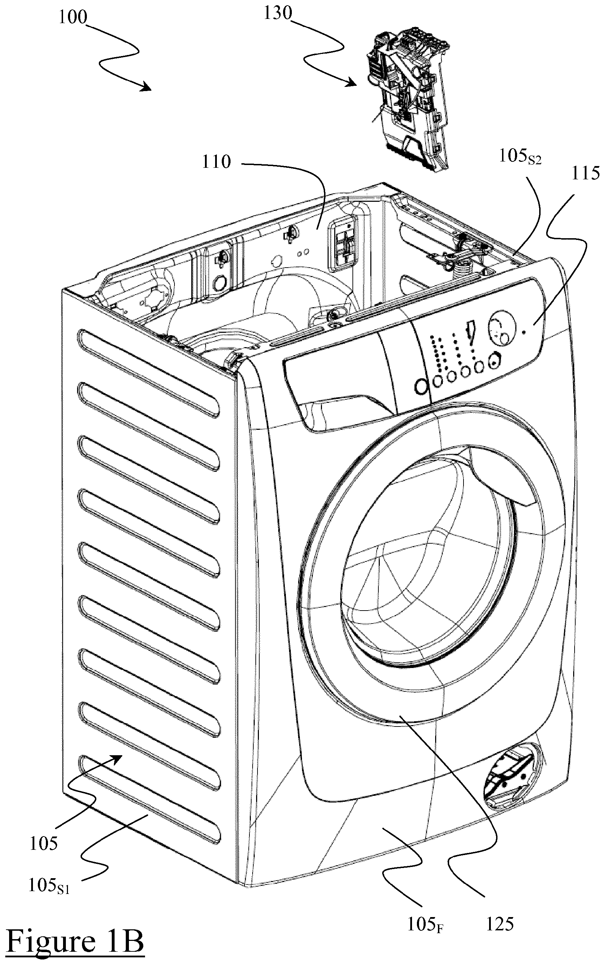

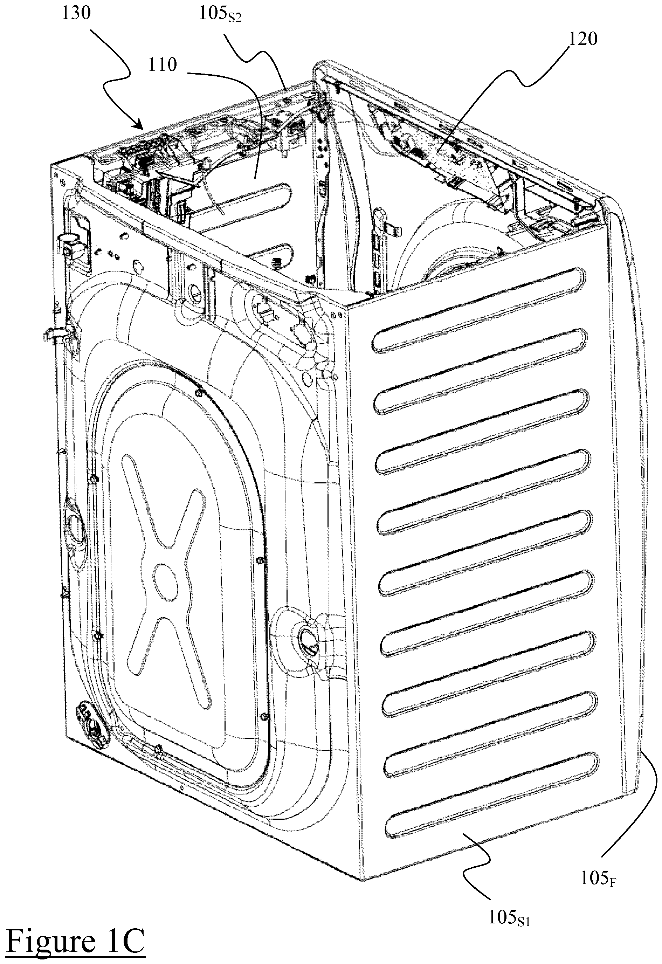

As can be best appreciated from **Figures 1B** and **1C****,** showing perspective front and rear views, respectively, of the appliance **100** (without the top wall **105_{T}**), the cabinet **105** encloses an inner compartment **110.**

The appliance **100** also comprises a user interface (UI) section. The UI section is preferably made up of a control panel **115,** preferably provided at (*e.g.,* a top right of) the front wall **105_{F}** (as illustrated in **Figures 1B** and **1C****)** for receiving user commands allowing to select/adjust operating parameters of the appliance **100,** and a UI control board **120,** preferably provided at a control panel **115** back facing the inner compartment **110** (as illustrated in **Figure 1C****),** for controlling appliance **100** operation according to the user commands.

As usual, the control panel **115** advantageously comprises touch-sensitive portions (for example, of the capacitive type) and/or mechanical portions (for example, comprising mechanical actuators such as push and/or rotating buttons, sliders and the like), whereas the UI control board **120** comprises electronic and/or electro-mechanic components responsive to said touch-sensitive and/or mechanical portions, and an appliance controller (not shown) for overseeing/managing operation of the appliance **100** (such as washing and/or drying operations thereof).

Preferably, the control panel **115** and the UI control board **120** are detachably mounted to a mounting frame of the front wall **105_{F}** (not visible), and are arranged and designed such that electric contact between the touch-sensitive and/or mechanical portions and the UI electronic board **120** is automatically established upon mounting. This greatly simplifies mechanical mounting and largely prevents faulty electric contacting.

For the sake of completeness, the inner compartment **110** of the exemplarily considered appliance **100** (which is intended to perform only laundry washing operations) also accommodates a tub (not visible), adapted to be filled with washing water, and a *e.g.* rotatable perforated drum (also not visible) mounted therein (in either a horizontal or vertical orientation) adapted to house the laundry to be treated (*i.e.,* the laundry to be washed, in the example at issue). Anyway, according to the considered appliance (and, hence, according to the items to be treated by it and according to the treatment it is intended to perform on them), the inner compartment **110** may accommodate, instead of the tub and the rotatable perforated drum, any item treatment chamber (*e.g.,* a rotatable, non-perforated drum in case of a laundry dryer, or two or more pull-out racks or baskets in case of a dishwasher, and the like).

The inner compartment **110** is accessible through an access door **125** (shown in a closed configuration) preferably provided on the front wall **105_{F}** of the cabinet **105** for loading/unloading the laundry.

In addition, the inner compartment **110** also accommodates a number of other electrically-operated devices (*e.g.*, electric motor for causing drum rotation, electro-hydraulic components, such as valves, for causing treatment fluids to be loaded and discharged during washing cycles, pumps, compressors, sensors), as well as an electric power supply assembly, or supply assembly, **130** (shown operatively separate from the appliance **100** in the partly exploded view of **Figure 1B**) adapted to be electrically coupled (*e.g.,* by wiring) to such devices for properly supplying/driving them.

A significant example of such electrical coupling is illustrated in **Figure 1C****,** showing the supply assembly **130** operatively associated with the appliance **100** (*e.g.,* fixed/mounted to the side wall **105_{S2}**, within the inner compartment **110**) and electrically coupled to the UI control board **120** provided at the control panel **115** back. Significance of such electrical coupling arises from the fact that effectively and correctly powering of electrically-delicate sections *(i.e.,* sections, just as the UI section, irreparably prone to faults when affected by over-powering or under-powering), which the proposed solution is mainly aimed at (as discussed below), is mandatory for meeting modern technological requirements.

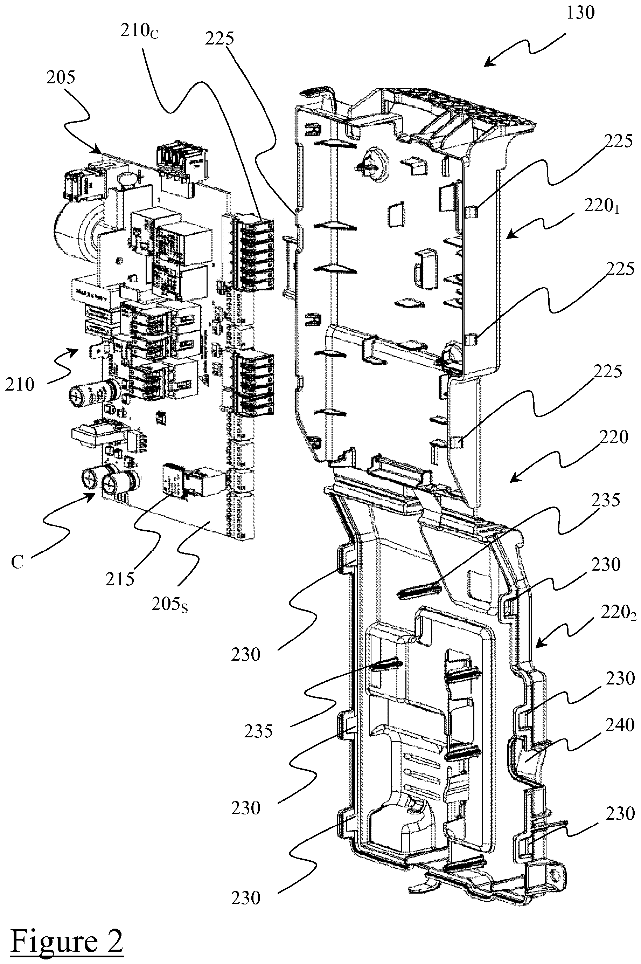

The supply assembly **130** (illustrated in the perspective exploded view of **Figure 2****,** to which reference will be also made hereinafter) preferably comprises a *"Printed Circuit Board"* (PCB) **205** populated with electronic components implementing electric power supply functionalities. As usual, such electronic components are mechanically supported by a non-conductive substrate **205_{S}** of the PCB **205,** and are electrically connected to each other by means of conductive tracks and pads (not visible) etched from *e.g.* copper sheets laminated onto the substrate **205_{S}.**

In the example herein considered, the electric power supply functionalities are achieved by means of *(i.e.,* the electronic components on the PCB **205** implement) a *"Switched-Mode Power Supply"* (SMPS) arrangement (globally denoted by the number reference **210**). Broadly speaking, the SMPS arrangement **210** on the PCB **205** (hereinafter, also referred to as SMPS module **205,210**) is configured to receive, at an input module thereof, an AC supply voltage (*e.g*., from the electric mains, not shown) and to provide, at an output module thereof comprising well-known transforming, rectifying, filtering and regulating components, a regulated DC supply voltage therefrom (hereinafter, DC supply voltage *V_{DC}*) adapted to electrically power/drive at least part of said electrically-operated devices. In order to achieve powering/driving of said electrically-operated devices, electrical coupling thereof to connectors **210_{C}** of the SMPS module **205,210** is required.

However, the SMPS module **205,210** may also be configured to provide, upon reception of the AC supply voltage, a number of *(e.g.,* two or more) different DC supply voltages, each one adapted to electrically power/drive different (groups of) electrically-operated devices. In this case, multiple connectors **210_{C}** (only two shown in the figure) and multiple electrical coupling thereto (not shown) may be provided.

As known, a regulated DC supply voltage (such as the DC supply voltage *V_{DC}*) is a DC supply voltage controlled so as to feature a substantially constant value, namely controlled so as to range/vary (*i.e.,* fluctuate), with respect to a predetermined (or expected/nominal/desired) value thereof, only between an upper boundary value higher than the nominal value and a lower boundary value lower than the nominal value (with such upper and lower boundary values that, according to the specific SMPS module, may be statically or dynamically set, as discussed below). The above said variation of the DC supply voltage *V_{DC}* with respect to its nominal value is commonly referred to as "ripple", and is caused by incomplete suppression of the alternating waveform components of the AC supply voltage.

As usual in SMPS modules, regulation (*i.e.,* dynamically setting of said upper and lower boundary values) may be achieved by means of switching elements (*e.g.*, transistors, not shown) continually switching between on and off states, and by properly (*e.g.*, dynamically) varying the on-to-off states time ratio.

From now on, reference will be made to components of the SMPS module **205,210** relevant for understating the invention, with the other, well-known components, that will be intentionally omitted for the sake of conciseness.

In this respect, the SMPS module **205,210** comprises a capacitive arrangement (*e.g*., two capacitive components, or capacitors, in parallel configuration, denoted as a whole by the reference **C**), part of the output module providing the DC supply voltage *V_{DC},* and a control unit **215** (for example, a microcontroller or a microprocessor) for managing SMPS module **205,210** operation (such as switching the switching elements between the on and off states, and dynamically varying the on-to-off states time ratio according to an actual value of the DC supply voltage *V_{DC}*).

The SMPS module **205,210** is preferably adapted to be enclosed within a *e.g.,* plastic enclosure **220** allowing fixing (hence, mechanical association) of the power supply assembly **130** to the appliance **100.** Enclosure **220** also provides protection of the electronic components of the SMPS module **205,210** against maneuver of an operator. Specifically, by stably enclosing the SMPS module **205,210** within the enclosure **220,** safe handling can be achieved during manufacturing and assembling operations. Indeed, any direct contact of the SMPS module **205,210** (and, especially, of the electronic components thereof) by an operator is avoided by "shielding effect" provided by the enclosure **220,** both when the SMPS module **205,210** has to be moved across different factory sectors and when the power supply assembly **130** has to be fixed/mounted to the appliance **100** and the SMPS module **205,210** electrically coupled to the electrically-operated devices.

As can be best appreciated in **Figure 2****,** the enclosure **220** preferably comprises first **220₁** and second **220₂** shells pivotally (*i.e.,* hingedly) coupled one to another at respective end sides thereof. Thanks to hinging, the shells **220₁,220₂** are allowed to rotate relative to one another, so that the enclosure **220** can take fully-opened and fully-closed configurations. In the fully-opened configuration (shown in **Figure 2**), easy housing of the SMPS module **205,210** is allowed (housing shells **220₁,220₂** separate from each other, exception made for their hinged sides), whereas, in the fully closed configuration (shown in **Figures 1B** and **1C**), the SMPS module **205,210** is firmly housed and retained between the housing shells **220₁,220₂** (housing shells **220₁,220₂** overlapping each other). Preferably, retaining action (in the closed configuration) is attained by snap-fitting coupling between the housing shells **220₁,220₂.** For example (as illustrated), flaps **225** are provided at side edges of one of the two shells **220₁,220₂** *(e.g.,* the shell **220₁** in the illustrated embodiment), and corresponding eyelets **230** are provided at side edges of the other shell **220₂,220₁,** so that, upon shells **220₁,220₂** overlapping, flaps **225** reversibly fit into the respective eyelets **230.** Preferably, SMPS module **205,210** housing into the enclosure **220** is assisted (*i.e.,* it can be univocally carried out by an operator) by delimiters/guides provided at one (or at least one) of the two shells **220₁,220₂.** For example (as illustrated), such delimiting/guiding action is attained by elongated members **235** provided at the shell **220₂.**

Shells **220₁,220₂** shaping provides for enclosure **220** passages (such as the passage **240**) making wiring between the SMPS module **205,210** therewithin and the electrically-operated devices of the appliance **100** (such as the electrical coupling between the SMPS module **205,210** and the UI control board **120** illustrated in **Figure 1C**) possible.

As mentioned in the introductory part of the present description, assembly operations such as finalization of the SMPS module **205,210** (including mounting of some plastic parts), enclosing the SMPS module **205,210** within the enclosure **220** and wiring of the SMPS module **205,210** *(i.e.,* wire connections to SMPS module **205,210** connectors), as well as power supply assembly **130** fixing/mounting to the appliance **100,** require a number of moving/maneuvers (*i.e.,* handling) by the operator. This drastically increases risks of unintentional damages (hence, faults) of the SMPS module **205,210** (*e.g*., electronic components de-soldering), which may severely impair operation thereof.

The Applicant has found that damages resulting by assembly operations most likely and frequently affect the capacitors **C** - *e.g.,* due to their non-negligible height extent from the PCB **205,** to the technique usually adopted for their soldering to the PCB **205** (which typically determines a relatively low capability of fixing to the PCB **205**), and/or to their handy position over the PCB **205** (such as at a PCB **205** side or, even worse, at a PCB **205** corner, as illustrated).

In this respect, the Applicant has addressed his efforts at quickly and easily detecting, at substantially any suitable stage of the appliance **100** manufacturing/assembling *(e.g.,* at a test phase), whether, as a result of said assembly operations, the capacitors **C** (or any other component of the output module) has been affected by damages - it being understood that the possibility of detecting, in a similar way, damages to other electronic components of the SMPS module **205,210** is not excluded (as discussed in the following).

According to the proposed solution, the DC supply voltage *V_{DC}* is monitored (at a predefined assembly/manufacturing step of the appliance **100**) for evaluating possible capacitors **C** damages. In order to achieve that, the control unit **215** is electrically coupled (*e.g*., directly or indirectly connected) to the capacitors **C** for receiving a test DC supply voltage *V_{DC,TEST},* and is configured to provide fault indications indicative that the capacitive arrangement **C** *(i.e.,* one of the capacitors **C,** or both of them) is affected by damages according to said test DC supply voltage *V_{DC,TEST}.* According to the proposed solution, the test DC supply voltage *V_{DC,TEST}* corresponds to the DC supply voltage *V_{DC}, i.e.* the test DC supply voltage *V_{DC,TEST}* is derived from (thus being indicative of) the DC supply voltage *V_{DC}.*

According to an exemplary, not limiting, embodiment (discussed below), the test DC supply voltage *V_{DC,TEST}* is equal, or substantially equal, to the DC supply voltage itself.

According to an exemplary, not limiting, alternative embodiment (discussed below as well), the test DC supply voltage *V_{DC,TEST}* is a scaled version of the DC supply voltage. Without losing of generality, any proper relationship between the test DC supply voltage *V_{DC,TEST}* and the DC supply voltage *V_{DC}* may be envisaged (such as shifting) in addition or in alternative to scaling, provided such a relationship relates to a well-defined and univocal correspondence.

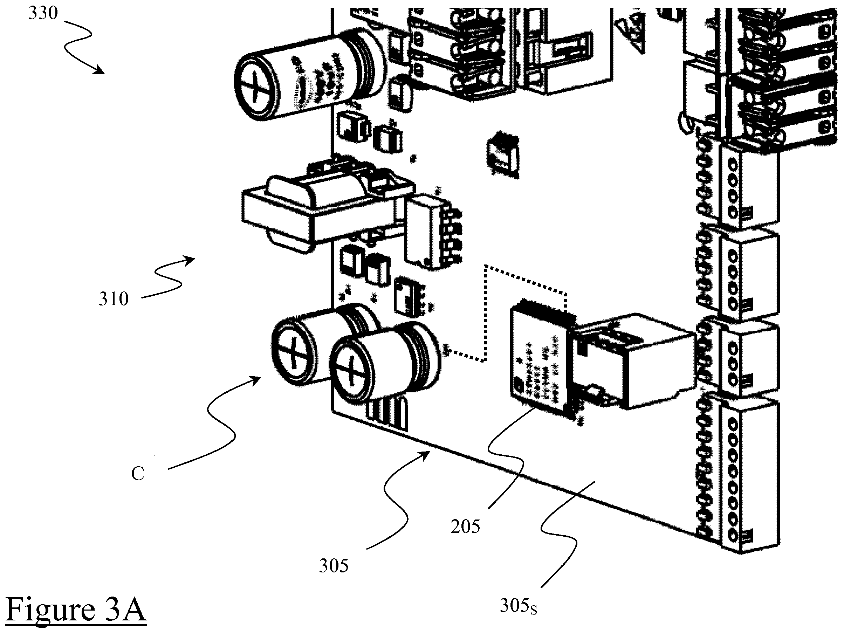

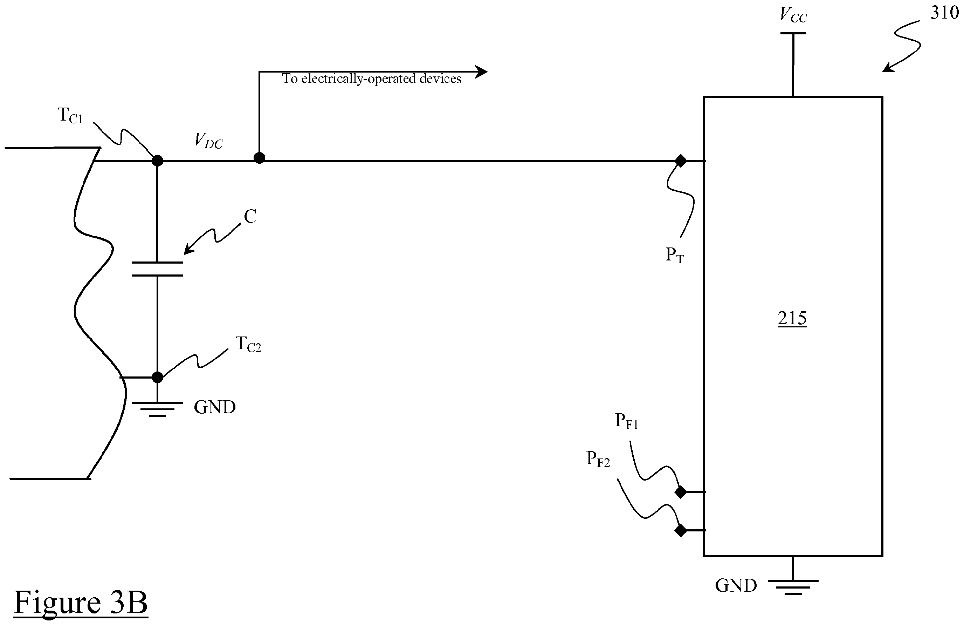

Reference will be first made to **Figure 3A****,** showing a close-up, partly see-through front view of a part of an electric power supply assembly **330** according to an embodiment of the invention (wherein the control unit **215** is directly connected to the capacitors **C**), and to **Figure 3B****,** showing a schematic circuit representation thereof.

By virtue of direct electrical connection between the capacitors **C** and the control unit **215,** in this specifically considered embodiment the test DC supply voltage *V_{DC,TEST}* is substantially equal to the DC supply voltage *V_{DC},* by the wording "substantially equal" meaning that the DC supply voltage *V_{DC}* received by the control unit **215** is the same DC supply voltage *V_{DC}* provided by the capacitors **C,** unless unavoidable non-idealities (such as electrical losses, parasitic capacitances, and disturbances/noises) affecting the DC supply voltage *V_{DC}* in the electrical direct path between the capacitors **C** and the control unit **215.**

As will be best understood in the following, direct electrical connection may be adopted under the assumption of *(i.e.,* it is made possible by) compatibility between the DC supply voltage *V_{DC}* and the operation swing of the control unit **215.** By operation swing it is meant the (*e.g.*, voltage) range the control unit **215** is allowed to operate (*i.e.,* the admissible voltage values it is allowed to correctly receive and process), and is determined by powering thereof. For the purposes of the present disclosure (as illustrated in **Figure 3B**), the control unit **215** is powered between a constant lower voltage (*e.g.,* a ground voltage GND, preferably equal to 0V, used as a reference voltage of the SMPS module **305,310**) and a constant upper voltage (or upper voltage *V_{CC},* with respect to the ground voltage GND), the latter provided by the SMPS module **305,310** (or, alternatively, during the test phase, by an external apparatus).

In order to provide electrical coupling (*e.g.,* direct electrical connection in the example at issue) between the capacitors **C** and the control unit **215,** the SMPS module **305,310** comprises a dedicated conductive track - conceptually shown in **Figure 3A** by a dashed line - between the capacitors **C** and a proper (*e.g.,* previously unused) input pin (hereinafter, test pin) **P_{T}** of the control unit **215.** By electrical viewpoint, as illustrated in **Figure 3B****,** the capacitors **C** have first terminals connected to each other thereby forming the common terminal providing the DC supply voltage *V_{DC}* (denoted by the reference **T_{C1}**) and second terminals connected to each other thereby forming another common terminal (denoted by the reference **T_{C2}**) for receiving the ground voltage GND, with the common terminal **T_{C1}** that is connected to the test pin **P_{T}** of the control unit **215.**

According to the example of **Figures 3A-3B****,** the control unit **215** is configured to provide said fault indications upon detecting that the DC supply voltage *V_{DC}* has a value above the upper boundary value (over-voltage) or below the lower boundary value (under-voltage). In other words, according to the proposed solution, the control unit **215** is configured to provide said fault indications upon detecting that the ripple voltage superimposed to the DC supply voltage *V_{DC}* has, in absolute value, an excessive amplitude. Otherwise stated, the control unit **215** is configured to provide said fault indications upon detecting that the DC supply voltage *V_{DC}* has a value outside a range comprising *(e.g.,* centered at) the nominal value thereof.

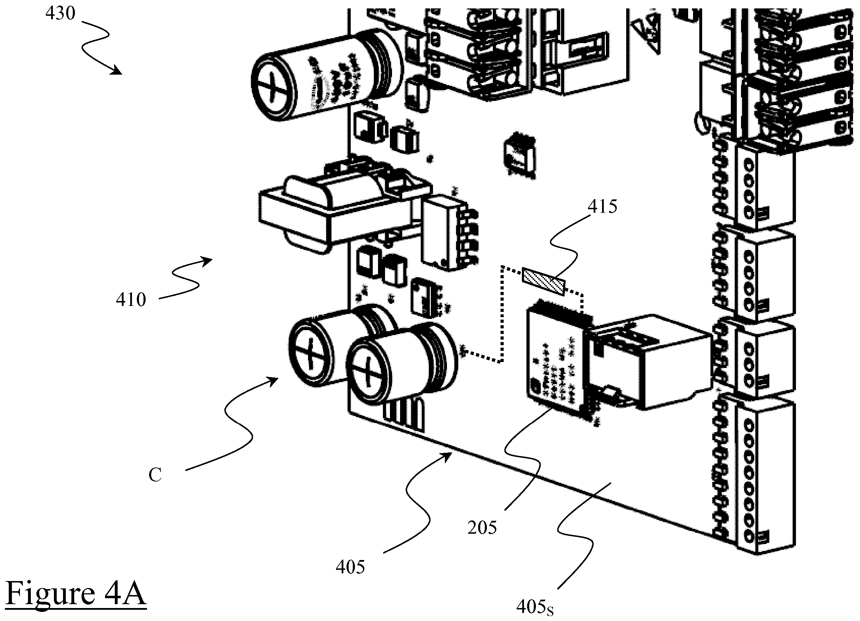

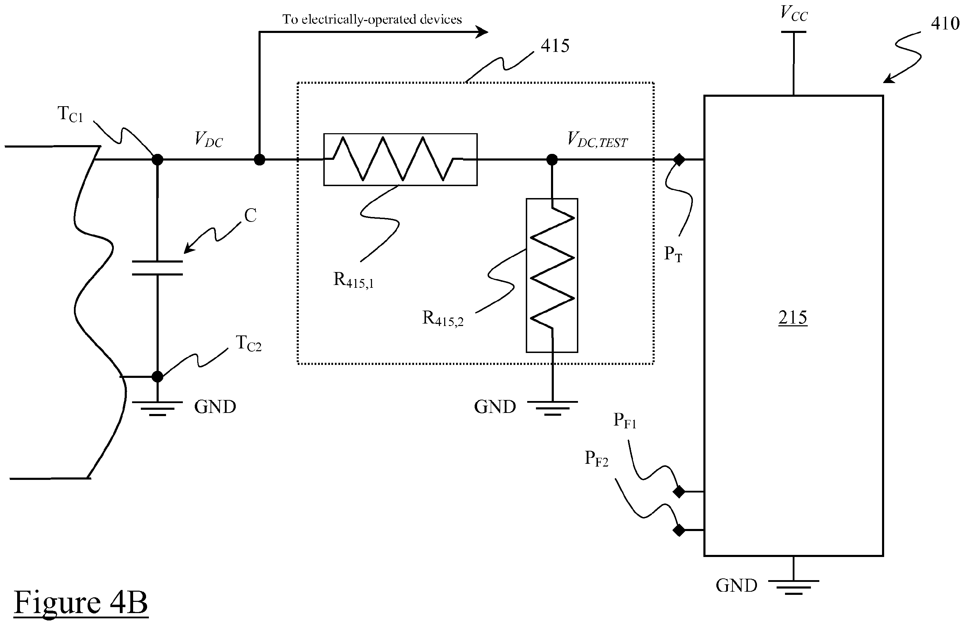

However, as visible in **Figures 4A** and **4B** (showing a close-up, partly see-through front view of a part of an electric power supply assembly **430** according to another embodiment of the invention, and a schematic circuit representation thereof, respectively), the capacitors **C** (or any other component of the output module) and the control unit **215** may be electrically connected to each other by means of an impedance arrangement **415** (as discussed below, the impedance arrangement **415** is particularly preferred in case that the DC output voltage *V_{DC}* is not within the operation swing of the control unit **215**).

Preferably, as visible in **Figure 4B****,** the impedance arrangement **415** is a voltage divider receiving the DC supply voltage *V_{DC}* and providing the test DC supply voltage *V_{DC,TEST}.* This provides a scaling of the DC supply voltage *V_{DC},* namely it produces a scaled output voltage *(i.e.,* the test DC supply voltage *V_{DC,TEST}*) that is a fraction of the DC supply voltage *V_{DC}*). In other words, the test DC supply voltage *V_{DC,TEST}* is scaled, with respect to the DC supply voltage *V_{DC},* by a scaling factor *SF* of the voltage divider (as discussed herebelow), such that the test DC supply voltage *V_{DC,TEST}* can be correctly received, and correctly processed, by the control unit **215.**

As should be readily understood, by virtue of said scaling, ripple superimposed to the test DC supply voltage *V_{DC,TEST}*, the upper and lower boundary values, and the upper and lower threshold amounts are also scaled (when referring to the test DC supply voltage *V_{DC,TEST}*) by the scaling factor *SF.* In other words, when, in order to monitor the DC supply voltage *V_{DC},* a scaled version thereof is used (*i.e.,* the test DC supply voltage *V_{DC,TEST}*), all parameters associated to the DC supply voltage *V_{DC}* taken into consideration for fault detection *(i.e.,* ripple, upper and lower boundary values, and upper and lower threshold amounts) have to be considered correspondingly scaled when associated to the test DC supply voltage *V_{DC,TEST}.*

Thus, according to the example of **Figures 4A-4B****,** the control unit **215** is configured to provide said fault indications upon detecting that the test DC supply voltage *V_{DC,TEST}* has a value above the (scaled) upper boundary value (over-voltage) or below the (scaled) lower boundary value (under-voltage). In other words, according to the proposed solution, the control unit **215** is configured to provide said fault indications upon detecting that the ripple voltage superimposed to the DC supply voltage *V_{DC}* (and, hence, to the test DC supply voltage *V_{DC,TEST}*) has, in absolute value, an excessive amplitude.

In the example at issue, the resistive arrangement comprises two resistors **R_{415,1},R_{415,2}** (whose resistances will be denoted hereinafter by *R_{415,1},R_{415,2}*, respectively).

A first terminal of the resistor **R_{415,1}** is coupled (*e.g.*, directly connected) to the common terminal **T_{C1}** of the capacitors C for receiving the DC supply voltage *V_{DC},* a second terminal of the resistor **R_{415,1}** is coupled *(e.g.,* directly connected) to a first terminal of the resistor **R_{415,2}** and to the test pin **P_{T}** of the control unit **215** for providing it with the test DC supply voltage *V_{DC,TEST}*, whereas the second terminal of the resistor **R_{415,2}** receives the ground voltage *GND.*

By virtue of such implementation, the test DC supply voltage *V_{DC,TEST}* is, with respect to the DC supply voltage *V_{DC},* scaled by a scaling factor *SF* depending on the equivalent resistance of the resistive arrangement **415** (*i.e., SF*=*R_{415,2}*/(*R_{415,1}*+*R_{415,2}*)).

Advantageously, resistances *R_{415,1},R_{415,2}* sizing is chosen so that any over-voltage or under-voltage of the test DC supply voltage *V_{DC,TEST}* (corresponding to any over-voltage or under-voltage of the DC supply voltage *V_{DC},* respectively) completely falls within the operation swing of the control unit **215,** and hence is distinctly detected.

Preferably, resistances *R_{415,1},R_{415,2}* sizing is such that the expected nominal value of the test DC supply voltage *V_{DC,TEST}* is in the middle of the operation swing of the control unit **215** (so that over-voltages or under-voltages having same maximum magnitude can be easily read and detected).

For example, in case that the upper voltage *V_{CC}* of the control unit **215** is equal to 5V (defining an operation swing of 5V) and the DC supply voltage *V_{DC}* is out of the operation swing (being for example equal to 12V), the test DC supply voltage *V_{DC,TEST}* can be conveniently set at 2,5V. Thus, in the considered example, the scaling factor *SF* allowing the test DC supply voltage *V_{DC,TEST}* to completely fall within the operation swing of the control unit **215** is about 4.8.

Thanks to the resistive arrangement **415,** the control unit **215** is allowed to correctly receive and process the test DC supply voltage *V_{DC,TEST}*, and to correctly detect ripple thereof (and over-voltage and under-voltage conditions).

As mentioned above, in both Figures **3A-3B** and **4A-4B** embodiments, said upper and lower boundary values (and, hence, the range) may be statically or dynamically set. In the latter case, such upper and lower boundary values may be dynamically derived/calculated/updated (by the control unit **215**) as maximum and minimum allowed percentage changes of the DC supply voltage *V_{DC}* (or of test DC supply voltage *V_{DC,TEST}*, as the case may be) with respect to the expected nominal value thereof. This is advantageous in both single and multiple DC supply voltages scenarios, as well as in dynamically-varied DC supply voltage scenarios, as the upper and lower boundary values may be dynamically derived/calculated/updated by the control unit **215** for the, or each, DC supply voltage *V_{DC}* (or test DC supply voltage *V_{DC,TEST}*) instead of being statically stored into the control unit **215** during a programming phase thereof.

When static setting of the upper and lower boundary values is used, however, other conditions may be used for discriminating absence/presence of SMPS module **305,310** faults. In this respect, in order to omit possible spurious electrical contributions (not relevant for evaluation of damages/faults of the capacitive arrangement **C**) and to exclude false damages detection, the control unit **215** may be preferably configured to provide said fault indications if said DC supply voltage *V_{DC}* (or test DC supply voltage *V_{DC,TEST}*) has a value above/below the upper/lower boundary values by upper/lower threshold amounts, respectively. Similarly to the above, said upper and lower threshold amounts may be derived/calculated by the control unit **215,** respectively, from said maximum and minimum allowed percentage changes of the DC supply voltage *V_{DC}* (and, hence, of test DC supply voltage *V_{DC,TEST}* when indirect connection between the control unit **215** and the capacitors **C** is provided) with respect to the expected nominal value thereof, which allows achieving effective and reliable detection.

Advantageously, in both Figures **3A-3B** and **4A-4B** embodiments, the control unit **215** is configured to acquire peak values of the DC supply voltage *V_{DC}* (or of the test DC supply voltage *V_{DC,TEST}*) over the test phase, and to provide said fault indications upon detecting that at least one of the acquired peak values is above the upper boundary (*e.g.*, by the upper threshold amount) or below the lower boundary value (*e.g.*, by the lower threshold amount). Preferably, in order to exclude false damages detection, the control unit **215** may be configured to provide said fault indications only when detection (of the over-voltage or under-voltage conditions) has lasted for a predefined time period and/or has occurred a predefined number of times.

Additionally or alternatively, the control unit **215** may also be configured to store said fault indications (so as to make them available at subsequent steps of the appliance manufacturing, or under appliance maintenance operations) *e.g.*, for diagnostic and statistical issues or for keeping trace of components ageing.

Without losing of generality, in both Figures **3A-3B** and **4A-4B** embodiments, the fault indications provided by the control unit **215** may consist of any proper information/data allowing an operator assigned to the test phase to univocally and clearly identify the fault conditions. By way of example only, the fault indications may comprise an alarm signal displayed on a simple, external test apparatus/device (*e.g.*, a personal computer, not shown, and a proper personal computer / control unit **215** interface), thus relying on the control unit **215** the task of identifying the over-voltage/under-voltage conditions. Alternatively, the fault indications may comprise only the detected peak values (provided either in the form of number list or in the form of "signals" displayed on a monitor), thus relying on the operator (or on the personal computer, *e.g.,* through a simple software tool) the task of identifying over-voltage/under-voltage conditions. In both cases, the proposed solution does not need the use of complex and costly dedicated test apparatus.

Finally, interfacing between the control unit **215** and the test apparatus may be advantageously achieved by means of one or more (*e.g.,* two) interfacing pins **P_{F1},P_{F2}** (*e.g.,* previously unused) of the control unit **215** (illustrated in **Figures 3B** and **4B****),** which are adapted to receive test instructions from the test apparatus and to provide it with said fault indications.

Naturally, in order to satisfy local and specific requirements, a person skilled in the art may apply to the solution described above many logical and/or physical modifications and alterations. More specifically, although the invention has been described with a certain degree of particularity with reference to preferred embodiments thereof, it should be understood that various omissions, substitutions and changes in the form and details as well as other embodiments are possible.

For example, although in the description explicit reference to acquisition of peak values of the DC supply voltage *V_{DC}* (or of the test DC supply voltage *V_{DC,TEST}*, as the case may be) has been made, this should not be construed limitatively. Indeed, additionally or alternatively to acquisition of peak values, it is possible to measure/acquire an average value of the DC supply voltage *V_{DC}* (or of the test DC supply voltage *V_{DC,TEST}*), to compare it to a predetermined average value (or, advantageously, to a values range comprising said predetermined average value) that is expected in absence of faults, and to determine faulty conditions based on said comparison (*e.g.*, based on whether the acquired average value is outside/inside said values range).

This may be the case of, for example, identification of electrostatic losses/discharges affecting one ore more components of the SMPS module **205-210, 305-310, 405-410** *(e.g.,* due to parasitic loads determining short-circuit conditions, or substantially short-circuit conditions), and resulting in a not negligible lowering of the average value of the DC supply voltage *V_{DC}* (or of the test DC supply voltage *V_{DC,TEST}*) with respect to the expected average value thereof.

Acquisition of the average value may be achieved by digital processing carried out by the control unit **215** upon reception (at the test pin **P_{T}** or, possibly, at another dedicated pin thereof, not shown) of the DC supply voltage *V_{DC}* (or of the test DC supply voltage *V_{DC,TEST}*). Alternatively, acquisition of the average value may be achieved analogically, *e.g.* by means of averaging circuits (such as R-C series circuits, not shown) between the output module of the SMPS module **205-210, 305-310, 405-410** and (*e.g.,* the test pin **P_{T}** or, possibly, another dedicated pin of) the control unit **215.**

Furthermore, although in the description explicit reference to a test DC supply voltage *V_{DC,TEST}* as a scaled version of the DC supply voltage *V_{DC}* has been made, any other relationship may be envisaged. For example, the possibility of providing a test DC supply voltage *V_{DC,TEST}* that is an amplified version of the DC supply voltage *V_{DC}* (possibly, in addition to shifting) is not excluded. This may be the case of, for example, components of the output module of the SMPS module **205-210, 305-310, 405-410** providing DC voltages quite lower than the output swing of the control unit **215.**

Moreover, the proposed solution lends itself to be implemented through an equivalent method (by using similar steps, removing some steps being not essential, or adding further optional steps); moreover, the steps may be performed in different order, concurrently or in an interleaved way (at least partly).

## Claims

1. Washing and/or drying appliance (**100**) comprising an electric power supply assembly (**130,330,430**) configured to receive an AC supply voltage and to provide a DC supply voltage (*V_{DC}*) therefrom, the DC supply voltage (*V_{DC}*) being adapted to power electrically-operated devices of the appliance (**100**),
wherein the electric power supply assembly (**130,330,430**) comprises:
an output module for providing the DC supply voltage (*V_{DC}*), and
a control unit (**215**) electrically coupled to at least one component (**C**) of the output module and **characterized in that** the control unit (15) is configured to receive a test DC supply voltage (*V_{DC,TEST}*) corresponding to the DC supply voltage (*V_{DC}*), and wherein
the control unit (**215**) is further configured to provide fault indications indicative that the least one component (**C**) of the output module is affected by damages upon detecting that said test DC supply voltage (*V_{DC,TEST}*) has a value outside a values range comprising a predetermined value of the test DC supply voltage (*V_{DC,TEST}*).

2. Washing and/or drying appliance (**100**) according to Claim 1, wherein the control unit (**215**) comprises at least one interfacing pin (**P_{F1},P_{F2}**) for interfacing of the control unit (**215**) to a test apparatus, the at least one interfacing pin (**P_{F1},P_{F2}**) being adapted to receive test instructions by the test apparatus and to allow the test apparatus to receive said fault indications.

3. Washing and/or drying appliance (**100**) according to any of the preceding Claims, wherein said values range comprises first and second values higher and lower, respectively, than the predetermined value of the test DC supply voltage (*V_{DC,TEST}*), said first and second values being set, respectively, according to maximum and minimum allowed percentage changes of the test DC supply voltage (*V_{DC,TEST}*) with respect to the predetermined value thereof.

4. Washing and/or drying appliance (100) according to any of the preceding Claims, wherein said electrically-operated devices comprise an appliance controller for managing appliance (100) operation, said appliance controller being powered by said DC supply voltage (*V_{DC}*).

5. Washing and/or drying appliance (100) according to any of the preceding Claims, wherein the electric power supply assembly (130,330,430) comprises a *"Switched-Mode Power Supply"* module (205-405,210-410), wherein said output module is the output module of the *"Switched-Mode Power Supply"* module (**205-405,210-410**), and wherein the at least one component (**C**) of the output module comprises a capacitive arrangement (**C**).

6. Washing and/or drying appliance (**100**) according to any of the preceding Claims, wherein the control unit (**215**) is configured to store said fault indications.

7. Washing and/or drying appliance (**100**) according to any of the preceding Claims, wherein the control unit (**215**) is configured to acquire peak values of the test DC supply voltage (*V_{DC,TEST}*), and to provide said fault indications upon detecting that at least one of the acquired peak values is outside said values range.

8. Washing and/or drying appliance (**100**) according to any of the preceding Claims, wherein
said at least one component (**C**) of the output module is directly connected to the control unit (**215**), the test DC supply voltage (*V_{DC,TEST}*) being substantially equal to the DC supply voltage (*V_{DC}*), or
said at least one component (**C**) of the output module is electrically coupled to the control unit (**215**) by interposition of an impedance arrangement (**415,R₄₁₅₁,R_{415,2}**).

9. Washing and/or drying appliance (**100**) according to Claim 8, wherein the impedance arrangement (**415,R₄₁₅₁,R_{415,2}**) is a voltage divider (**R₄₁₅₁,R_{415,2}**) receiving the DC supply voltage (*V_{DC}*) and providing the test DC supply voltage (*V_{DC,TEST}*), the test DC supply voltage (*V_{DC,TEST}*) being scaled, with respect to the DC supply voltage (*V_{DC}*), by a scaling factor *(SF)* of the voltage divider (**R₄₁₅₁,R_{415,2}**).

10. Washing and/or drying appliance (**100**) according to Claim 9, wherein the control unit (**215**) is powered between first (*V_{CC})* and second (GND) voltages defining an operation swing of the control unit (**215**), said scaling factor (*SF*) allowing the test DC supply voltage (*V_{DC,TEST}*) to fall within said operation swing.

11. Washing and/or drying appliance (**100**) according to any of the preceding Claims, wherein the electrically-operated devices comprise a user interface, the user interface having a control panel (**115**) for receiving user commands allowing to select/adjust operating parameters of the appliance (**100**), and a user interface control board (**120**) for controlling appliance (**100**) operation according to the user commands, and wherein the electric power supply assembly (**130,330,430**) is electrically coupled with the user interface control board (**120**) for powering it.

12. Washing and/or drying appliance (**100**) according to any of the preceding Claims, wherein the electric power supply assembly (**130,330,430**) comprises an enclosure (**220**) for allowing protection of electric power supply assembly (**130,330,430**) components.

13. Washing and/or drying appliance (**100**) according to any of the preceding Claims, wherein the appliance (**100**) is a laundry washing and/or drying appliance.

14. Washing and/or drying appliance (**100**) according to any Claim from 1 to 12, wherein the appliance (**100**) is a dishwashing appliance.

15. Method for assembling a washing and/or drying appliance (**100**) according to any of the proceeding claims comprising:
mounting an electric power supply assembly (130,330,430) within the appliance (100) and electrically coupling it to electrically-operated devices of the appliance (100), the electric power supply assembly (130,330,430) having an output module for providing a DC supply voltage (*V_{DC}*) from an AC supply voltage for powering said electrically-operated devices, and **characterized by** comprising
performing an electrical test on said electric power supply assembly (**130,330,430**) comprising:
receiving a test DC supply voltage (*V_{DC,TEST}*) corresponding to the DC supply voltage (*V_{DC}*),
comparing said test DC supply voltage (*V_{DC,TEST}*) with first and second values higher and lower, respectively, than a predetermined value of the test DC supply voltage (*V_{DC,TEST}*), and
inferring a fault condition of the output module if said test DC supply voltage (*V_{DC,TEST}*) is higher than said first value or lower than said second value.

16. Method according to Claim 15, wherein the electric power supply assembly (**130,330,430**) comprises a *"Switched-Mode Power Supply"* module (**205-405,210-410**), and wherein said mounting an electric power supply assembly (**130,330,430**) within the appliance (**100**) comprises:
enclosing the *"Switched-Mode Power Supply"* module (**205-405,210-410**) within an enclosure (**220**) thereby obtaining said power supply assembly (**130,330,430**), and
fixing the power supply assembly (**130,330,430**) to the appliance (**100**) by means of said enclosure (**220**).

17. Method according to Claim 15 or 16, wherein the control unit (**215**) comprises a test pin (**P_{T}**) for receiving the test DC supply voltage (*V_{DC,TEST}*), and wherein said performing an electrical test on said electric power supply assembly (**130,330,430**) comprises:
connecting a test apparatus to at least one interfacing pin (**P_{F1},P_{F2}**) of the control unit (**215**), and
causing the test apparatus to provide test instructions to the control unit (**215**) and to receive said fault indications.

## Patentansprüche

1. Wasch- und/oder Trocknungsgerät (100), das eine Stromversorgungsanordnung (130, 330, 430) umfasst, die konfiguriert ist, eine Versorgungswechselspannung zu empfangen und eine Versorgungsgleichspannung (*V_{DC}*) bereitzustellen, wobei die Versorgungsgleichspannung (*V_{DC}*) ausgelegt ist, elektrisch betriebene Vorrichtungen des Geräts (100) mit Strom zu versorgen,
wobei die Stromversorgungsanordnung (130, 330, 430) Folgendes umfasst:
ein Ausgangsmodul zum Bereitstellen der Versorgungsgleichspannung (*V_{DC}*), und
eine Steuereinheit (215), die mit wenigstens einer Komponente (C) des Ausgangsmoduls elektrisch gekoppelt ist, **dadurch gekennzeichnet, dass** die Steuereinheit (15) konfiguriert ist, eine Test-Versorgungsgleichspannung (*V_{DC,TEST}*), die der Versorgungsgleichspannung *(VDC)* entspricht, zu empfangen, wobei
die Steuereinheit (215) ferner konfiguriert ist, beim Detektieren, dass die Test-Versorgungsgleichspannung (*V_{DC,TEST}*) einen Wert außerhalb eines Wertebereichs hat, der einen festgelegten Wert für die Test-Versorgungsgleichspannung (*V_{DC,TEST}*) umfasst, Fehlermeldungen bereitzustellen, die anzeigen, dass die wenigstens eine Komponente (C) des Ausgangsmoduls beschädigt ist.

2. Wasch- und/oder Trocknungsgerät (100) nach Anspruch 1, wobei die Steuereinheit (215) wenigstens einen Schnittstellen-Pin (P_{F1}, P_{F2}) umfasst, der eine Schnittstelle der Steuereinheit (215) mit einer Testvorrichtung bildet, wobei der wenigstens eine Schnittstellen-Pin (P_{F1}, P_{F2}) ausgelegt ist, Testanweisungen durch die Testvorrichtung zu empfangen und zu ermöglichen, dass die Testvorrichtung die Fehlermeldungen empfängt.

3. Wasch- und/oder Trocknungsgerät (100) nach einem der vorhergehenden Ansprüche, wobei der Wertebereich einen ersten und einen zweiten Wert umfasst, die jeweils höher und niedriger als der festgelegte Wert der Test-Versorgungsgleichspannung (*V_{DC,TEST}*) sind, wobei der erste und der zweite Wert jeweils entsprechend einer maximalen und minimalen zulässigen prozentualen Änderung der Test-Versorgungsgleichspannung (*V_{DC,TEST}*) in Bezug auf den festgelegten Wert eingestellt sind.

4. Wasch- und/oder Trocknungsgerät (100) nach einem der vorhergehenden Ansprüche, wobei die elektrisch betriebenen Vorrichtungen eine Gerätesteuerung zum Verwalten eines Betriebs des Geräts (100) umfassen, wobei die Gerätesteuerung durch die Versorgungsgleichspannung (*V_{DC}*) betrieben wird.

5. Wasch- und/oder Trocknungsgerät (100) nach einem der vorhergehenden Ansprüche, wobei die Stromversorgungsanordnung (130, 330, 430) ein *"Switched-Mode Power Supply"-Modul* (205-405, 210-410) umfasst, wobei das Ausgangsmodul das Ausgangsmodul des *"Switched-Mode Power Supply"-Moduls* (205-405, 210-410) ist und wobei die wenigstens eine Komponente (C) des Ausgangsmoduls eine Kondensatoranordnung (C) umfasst.

6. Wasch- und/oder Trocknungsgerät (100) nach einem der vorhergehenden Ansprüche, wobei die Steuereinheit (215) konfiguriert ist, Fehlermeldungen zu speichern.

7. Wasch- und/oder Trocknungsgerät (100) nach einem der vorhergehenden Ansprüche, wobei die Steuereinheit (215) konfiguriert ist, Spitzenwerte der Test-Versorgungsgleichspannung (*V_{DC,TEST}*) zu erfassen und Fehlermeldungen bereitzustellen, wenn detektiert wird, dass wenigstens einer der erfassten Spitzenwerte außerhalb des Wertebereichs liegt.

8. Wasch- und/oder Trocknungsgerät (100) nach einem der vorhergehenden Ansprüche, wobei
die wenigstens eine Komponente (C) des Ausgangsmoduls mit der Steuereinheit (215) direkt verbunden ist, wobei die Test-Versorgungsgleichspannung *(VDC,TEST)* im Wesentlichen gleich der Versorgungsgleichspannung (*V_{DC}*) ist, oder
die wenigstens eine Komponente (C) des Ausgangsmoduls mit der Steuereinheit (215) elektrisch gekoppelt ist, indem dazwischen eine Impedanzanordnung (415, R₄₁₅₁, R_{415,2}) angeordnet ist.

9. Wasch- und/oder Trocknungsgerät (100) nach Anspruch 8, wobei die Impedanzanordnung (415, R₄₁₅₁, R_{415,2}) ein Spannungsteiler (R₄₁₅₁, R_{415,2}) ist, der die Versorgungsgleichspannung (*V_{DC}*) empfängt und die Test-Versorgungsgleichspannung (*VDC,TEST*) bereitstellt, wobei die Test-Versorgungsgleichspannung (*V_{DC,TEST}*) in Bezug auf die Versorgungsgleichspannung (*V_{DC}*) mit einem Skalierungsfaktor (*SF*) des Spannungsteilers (R₄₁₅₁, R_{415,2}) skaliert ist.

10. Wasch- und/oder Trocknungsgerät (100) nach Anspruch 9, wobei die Steuereinheit (215) durch die erste (Vcc) und die zweite (GND) Spannung betrieben wird, die eine Betriebsschwankungsbreite der Steuereinheit (215) definieren, wobei es der Skalierungsfaktor (*SF*) ermöglicht, dass die Test-Versorgungsgleichspannung (*V_{DC,TEST}*) in diese Betriebsschwankungsbreite fällt.

11. Wasch- und/oder Trocknungsgerät (100) nach einem der vorhergehenden Ansprüche, wobei die elektrisch betriebenen Vorrichtungen ferner eine Anwenderschnittstelle, wobei die Anwenderschnittstelle ein Bedienfeld (115) zum Empfangen von Anwenderbefehlen aufweist, um Betriebsparameter des Geräts (100) auswählen bzw. einstellen zu können, und eine Anwenderschnittstellen-Steuerplatine (120) zum Steuern des Betriebs des Geräts (100) gemäß den Anwenderbefehlen umfasst, und wobei die Stromversorgungsanordnung (130, 330, 430) mit der Anwenderschnittstellen-Steuerplatine (120) für die Stromversorgung elektrisch gekoppelt ist.

12. Wasch- und/oder Trocknungsgerät (100) nach einem der vorhergehenden Ansprüche, wobei die Stromversorgungsanordnung (130, 330, 430) ein Gehäuse (220) umfasst, um die Komponenten der Stromversorgungsanordnung (130, 330, 430) zu schützen.

13. Wasch- und/oder Trocknungsgerät (100) nach einem der vorhergehenden Ansprüche, wobei das Gerät (100) ein Gerät zum Waschen und/oder Trocknen von Wäsche ist.

14. Wasch- und/oder Trocknungsgerät (100) nach einem der Ansprüche 1 bis 12, wobei das Gerät (100) ein Geschirrspülgerät ist.

15. Verfahren zum Zusammenbauen eines Wasch- und/oder Trocknungsgeräts (100) nach einem der vorhergehenden Ansprüche, wobei das Verfahren die folgenden Schritte umfasst:
Montieren einer Stromversorgungsanordnung (130, 330, 430) in das Gerät (100) und elektrisches Koppeln mit den elektrisch betriebenen Vorrichtungen des Geräts (100), wobei die Stromversorgungsanordnung (130, 330, 430) ein Ausgangsmodul zum Bereitstellen einer Versorgungsgleichspannung *(VDC)* aus einer Versorgungswechselspannung hat, um die elektrisch betriebenen Vorrichtungen zu betreiben, und wobei das Verfahren **dadurch gekennzeichnet ist, dass** es die folgenden Schritte umfasst:
Durchführen eines elektrischen Tests der Stromversorgungsanordnung (130, 330, 430), der die folgenden Schritte umfasst:
Empfangen einer Test-Versorgungsgleichspannung (*VDC,TEST*) entsprechend der Versorgungsgleichspannung (*V_{DC}*),
Vergleichen der Test-Versorgungsgleichspannung (*VDC,TEST*) mit einem ersten und zweiten Wert, die jeweils höher und niedriger als ein festgelegter Wert der Test-Versorgungsgleichspannung (*V_{DC,TEST}*) sind, und
Folgern eines Fehlerzustands des Ausgangsmoduls, falls die Test-Versorgungsgleichspannung (*V_{DC,TEST}*) höher als der erste Wert oder niedriger als der zweite Wert ist.

16. Verfahren nach Anspruch 15, wobei die Stromversorgungsanordnung (130, 330, 430) ein *"Switched-Mode Power Supply"-Modul* (205-405, 210-410) umfasst und wobei das Montieren der Stromversorgungsanordnung (130, 330, 430) in das Gerät (100) die folgenden Schritte umfasst:
Umschließen des *"Switched-Mode Power Supply"-Moduls* (205-405, 210-410) mit einem Gehäuse (220), wodurch die Stromversorgungsanordnung (130, 330, 430) erhalten wird, und
Fixieren der Stromversorgungsanordnung (130, 330, 430) an dem Gerät (100) mittels des Gehäuses (220).

17. Verfahren nach Anspruch 15 oder 16, wobei die Steuereinheit (215) einen Test-Pin (P_{T}) zum Empfangen der Test-Versorgungsgleichspannung (*V_{DC,TEST}*) umfasst und wobei das Durchführen eines elektrischen Tests bei der Stromversorgungsanordnung (130, 330, 430) die folgenden Schritte umfasst:
Verbinden einer Testvorrichtung mit wenigstens einem Schnittstellen-Pin (P_{F1}, P_{F2}) der Steuereinheit (215) und
Veranlassen, dass die Testvorrichtung Testanweisungen für die Steuereinheit (215) bereitstellt und die Fehlermeldungen empfängt.

## Revendications

1. Machine à laver et/ou à sécher **(100)** comprenant un ensemble d'alimentation en énergie électrique **(130, 330, 430)** configuré pour recevoir une tension d'alimentation alternative et, à partir de celle-ci, pour délivrer une tension d'alimentation continue (*V_{DC}*), la tension d'alimentation continue (*V_{DC}*) étant adaptée à alimenter des dispositifs à fonctionnement électrique de la machine (**100**),
l'ensemble d'alimentation en énergie électrique **(130, 330, 430)** comprenant :
un module de sortie destiné à délivrer la tension d'alimentation continue (*V_{DC}*), et
une unité de commande **(215)** couplée électriquement à au moins un composant **(C)** du module de sortie, et **caractérisée en ce que** l'unité de commande **(15)** est configurée pour recevoir une tension d'alimentation continue de test (*V_{DC,TEST}*) correspondant à la tension d'alimentation continue (*V_{DC}*), et
l'unité de commande **(215)** étant configurée en outre pour délivrer des indications de défaut indiquant que l'au moins un composant **(C)** du module de sortie est endommagé en cas de détection que ladite tension d'alimentation continue de test (*V_{DC,TEST}*) prend une valeur qui sort d'une plage de valeurs comprenant une valeur prédéterminée de la tension d'alimentation continue de test (*V_{DC,TEST}*)*.*

2. Machine à laver et/ou à sécher **(100)** selon la revendication 1, dans laquelle l'unité de commande **(215)** comprend au moins une broche d'interfaçage (**P_{F1}, P_{F2}**) destinée à interfacer l'unité de commande **(215)** avec un appareil de test, l'au moins une broche d'interfaçage (**P_{F1}, P_{F2}**) étant adaptée à recevoir des instructions de test par l'appareil de test et à permettre à l'appareil de test de recevoir lesdites indications de défaut.

3. Machine à laver et/ou à sécher (100) selon l'une quelconque des revendications précédentes, dans laquelle ladite plage de valeurs comprend des première et deuxième valeurs respectivement supérieure et inférieure à la valeur prédéterminée de la tension d'alimentation continue de test (*V_{DC,TEST}*), lesdites première et deuxième valeurs étant fixées selon des variations en pourcentage permises respectivement maximale et minimale de la tension d'alimentation continue de test (*V_{DC,TEST}*) par rapport à sa valeur prédéterminée.

4. Machine à laver et/ou à sécher (**100**) selon l'une quelconque des revendications précédentes, dans laquelle lesdits dispositifs à fonctionnement électrique comprennent un contrôleur de machine destiné à gérer le fonctionnement de la machine (**100**), ledit contrôleur de machine étant alimenté par ladite tension d'alimentation continue (*V_{DC}*).

5. Machine à laver et/ou à sécher (**100**) selon l'une quelconque des revendications précédentes, dans laquelle l'ensemble d'alimentation en énergie électrique **(130, 330, 430)** comprend un module de type *"Alimentation à Découpage"* **(205-405, 210-410),** dans laquelle ledit module de sortie est le module de sortie du module de type *"Alimentation à Découpage"* **(205-405, 210-410),** et dans laquelle l'au moins un composant (**C**) du module de sortie comprend un montage capacitif (**C**).

6. Machine à laver et/ou à sécher (**100**) selon l'une quelconque des revendications précédentes, dans laquelle l'unité de commande (**215**) est configurée pour mémoriser lesdites indications de défaut.

7. Machine à laver et/ou à sécher **(100)** selon l'une quelconque des revendications précédentes, dans laquelle l'unité de commande **(215)** est configurée pour acquérir des valeurs de crête de la tension d'alimentation continue de test (*V_{DC,TEST}*), et pour délivrer lesdites indications de défaut en cas de détection qu'au moins une des valeurs de crête acquises sort de ladite plage de valeurs.

8. Machine à laver et/ou à sécher **(100)** selon l'une quelconque des revendications précédentes, dans laquelle
ledit au moins un composant (**C**) du module de sortie est directement connecté à l'unité de commande **(215),** la tension d'alimentation continue de test (*V_{DC,TEST}*) étant sensiblement égale à la tension d'alimentation continue (*V_{DC}*), ou
ledit au moins un composant (**C**) du module de sortie est couplé électriquement à l'unité de commande **(215)** par interposition d'un montage d'impédance **(415, R₄₁₅₁, R_{415,2}**).

9. Machine à laver et/ou à sécher **(100)** selon la revendication 8, dans laquelle le montage d'impédance **(415, R₄₁₅₁, R_{415,2}**) est un diviseur de tension (**R₄₁₅₁, R_{415,2}**) recevant la tension d'alimentation continue (*V_{DC}*) et délivrant la tension d'alimentation continue de test *(VDC,_{TEST}*), la tension d'alimentation continue de test (*V_{DC,TEST}*) étant mise à l'échelle, par rapport à la tension d'alimentation continue (*V_{DC}*), au moyen d'un facteur d'échelle (*SF*) du diviseur de tension **(R₄₁₅₁, R_{415,2}**).

10. Machine à laver et/ou à sécher (**100**) selon la revendication 9, dans laquelle l'unité de commande (**215**) est alimentée entre des première (Vcc) et deuxième (GND) tensions définissant une amplitude de fonctionnement de l'unité de commande (**215**), ledit facteur d'échelle *(SF)* permettant à la tension d'alimentation continue de test (*V_{DC,TEST}*) de s'inscrire dans ladite amplitude de fonctionnement.

11. Machine à laver et/ou à sécher (**100**) selon l'une quelconque des revendications précédentes, dans laquelle les dispositifs à fonctionnement électrique comprennent une interface-utilisateur, l'interface-utilisateur étant pourvue d'un panneau de commande (**115**) destiné à recevoir des commandes utilisateurs permettant de sélectionner/régler des paramètres de fonctionnement de la machine (**100**), et une carte de commande (**120**) d'interface-utilisateur destinée à commander le fonctionnement de la machine (**100**) selon les commandes utilisateurs, et dans laquelle l'ensemble d'alimentation en énergie électrique (**130, 330, 430**) est couplé électriquement à la carte de commande (**120**) d'interface-utilisateur pour en assurer l'alimentation.

12. Machine à laver et/ou à sécher (**100**) selon l'une quelconque des revendications précédentes, dans laquelle l'ensemble d'alimentation en énergie électrique **(130, 330, 430)** comprend un boîtier (**220**) destiné à assurer la protection de composants de l'ensemble d'alimentation en énergie électrique **(130, 330, 430).**

13. Machine à laver et/ou à sécher (**100**) selon l'une quelconque des revendications précédentes, laquelle machine (**100**) est une machine à laver et/ou à sécher le linge.

14. Machine à laver et/ou à sécher (**100**) selon l'une quelconque des revendications 1 à 12, laquelle machine (**100**) est une machine à laver la vaisselle.

15. Procédé d'assemblage d'une machine à laver et/ou à sécher (**100**) selon l'une quelconque des revendications précédentes, comprenant :
le montage d'un ensemble d'alimentation en énergie électrique **(130, 330, 430)** à l'intérieur de la machine (**100**) et son couplage électrique à des dispositifs à fonctionnement électrique de la machine (**100**), l'ensemble d'alimentation en énergie électrique (**130, 330, 430**) étant pourvu d'un module de sortie destiné à délivrer une tension d'alimentation continue (*V_{DC}*) à partir d'une tension d'alimentation alternative, destinée à alimenter lesdits dispositifs à fonctionnement électrique, et **caractérisé en ce qu'**il comprend
la réalisation d'un test électrique sur ledit ensemble d'alimentation en énergie électrique **(130, 330, 430),** comprenant :
la réception d'une tension d'alimentation continue de test (*V_{DC,TEST}*) correspondant à la tension d'alimentation continue (*V_{DC}*), et
la comparaison de ladite tension d'alimentation continue de test (*V_{DC,TEST}*) à des première et deuxième valeurs respectivement supérieure et inférieure à une valeur prédéterminée de la tension d'alimentation continue de test (*V_{DC,TEST}*)*,* et
la déduction de l'existence d'un état défectueux du module de sortie si ladite tension d'alimentation continue de test (*V_{DC,TEST}*) est supérieure à ladite première valeur ou inférieure à ladite deuxième valeur.

16. Procédé selon la revendication 15, dans lequel l'ensemble d'alimentation en énergie électrique **(130, 330, 430)** comprend un module de type *"Alimentation à Découpage"* **(205-405, 210-410),** et dans lequel ledit montage d'un ensemble d'alimentation en énergie électrique **(130, 330, 430)** à l'intérieur de la machine (**100**) comprend :
l'enfermement du module de type *"Alimentation à Découpage"* **(205-405, 210-410)** à l'intérieur d'un boîtier (**220**) de manière à obtenir ledit ensemble d'alimentation en énergie **(130, 330, 430),** et
la fixation de l'ensemble d'alimentation en énergie **(130, 330, 430)** à la machine (**100**) au moyen dudit boîtier (**220**).

17. Procédé selon la revendication 15 ou 16, dans lequel l'unité de commande (**215**) comprend une broche de test (**P_{T}**) destinée à recevoir la tension d'alimentation continue de test (*V_{DC,TEST}*), et dans lequel ladite réalisation d'un test électrique sur ledit ensemble d'alimentation en énergie électrique () comprend :
la connexion d'un appareil de test à au moins une broche d'interfaçage (**P_{F1}, P_{F2}**) de l'unité de commande (**215**), et
la commande à l'appareil de test de délivrer des instructions de test à l'unité de commande (**215**) et à recevoir lesdites indications de défaut.
